Europäisches Patentamt

European Patent Office

Office européen des brevets

(19)

(11) Veröffentlichungsnummer : **0 103 084**

**B1**

(12) **EUROPÄISCHE PATENTSCHRIFT**

(45) Veröffentlichungstag der Patentschrift :
07.09.88

(51) Int. Cl.⁴ : **H 01 L 31/10, H 01 L 31/18**

(21) Anmeldenummer : 83106055.3

(22) Anmeldetag : 21.06.83

(54) Verfahren zur Herstellung einer planaren Avalanche-Fotodiode mit langwelliger Empfindlichkeitsgrenze über 1,3 um.

(30) Priorität : 21.07.82 DE 3227263

(43) Veröffentlichungstag der Anmeldung :
21.03.84 Patentblatt 84/12

(45) Bekanntmachung des Hinweises auf die Patenterteilung : 07.09.88 Patentblatt 88/36

(84) Benannte Vertragsstaaten :
DE FR GB

(73) Patentinhaber : Siemens Aktiengesellschaft Berlin und München
Wittelsbacherplatz 2
D-8000 München 2 (DE)

(72) Erfinder : Trommer, Reiner, Dr.
Scherbaumstrasse 9b
D-8000 München 83 (DE)

(56) Entgegenhaltungen :
EP-A- 0 043 734
EP-A- 0 053 513
GB-A- 2 060 257
IEEE JOURNAL OF QUANTUM ELECTRONICS, Band QE-17, Nr. 2, Februar 1981, Seiten 250-254, IEEE, New York, US; H. ANDO et al.: InGaAs/InP separated absorption and multiplication regions avalanche photodiode using liquid- and vapor-phase epitaxies"
ELECTRONICS LETTERS, Band 17, Nr. 22, 29. Oktober 1981, Seiten 826-82, Hitchin GB; T. SHIRAI et al.: "1.3 Mum InP/InGaAsP planar avalanche photodiodes"
JAPANESE JOURNAL OF APPLIED PHYSICS, Band 20, Nr. 4, April 1981, Seiten L313-L316, Tokyo, JP; K. TAKAHEI et al.: "Instability of In-Ga-As-P liquid solution during low temperature LPE of $In_{1-x}Ga_xAs_{1-y}P_y$ on InP"
JOURNAL OF APPLIED PHYSICS, Band 51, Nr, 4, April 180, Seiten 2255-2257, American Institute of Physics, New York, US; M. CHU et al.: "Liquid phase expitaxial growth of $CdTe/Hg_{1-x}Cd_xTe$ multilayers (0.3 x 0.5)"

EP 0 103 084 B1

IEEE JOURNAL OF QUANTUM ELECTRONICS, Band QE-17, Nr. 2, Februar 1981, Seiten 260-264, IEEE, New York, US; V. DIADIUK et al.: "Low dark-current, high gain GaInAs/InP avalanche photodetectors"

APPLIED PHYSICS LETTERS, Band 35, Nr. 3, 1. August 1979, Seiten 251-253, American Institute of Physics, New York, US; K. NISHIDA et al.: "InGaAsP heterostructure avalanche photodiodes with high avalanche gain"

JAPANESE JOURNAL OF APPLIED PHYSICS, Band 20, Nr. 11, November 1981, Seiten L771-L773, Tokyo, JP; H. KANBE et al.: "Anomalous behavior in an InGaAs/InP heterojunction switching photodiode"

## Beschreibung

Die vorliegende Erfindung bezieht sich auf ein Verfahren zur Herstellung einer planaren Avalanche-Fotodiode mit langwelliger Empfindlichkeitsgrenze über 1,3 µm, wie es im Oberbegriff des Patentanspruchs 1 angegeben ist.

Fotodioden mit Avalanche-Effekt, die für den Wellenlängenbereich bis 1,65 µm und den Einsatz in optischen Nachrichtenübertragungssystemen mit Lichtwellenleitern geeignet sind, sind bekannt. Zum Beispiel sind aus « Electronic Letters », Bd. 16 (1980), Seite 163-165, aus « IEEE J. Quant. Electr. », Bd. 17 (1981), Seite 260-264 und « Appl. Phys. Letters », Bd. 39 (1981), Seite 402-404, Mesa-Dioden für diesen Zweck bekannt. Bei diesem speziellen Aufbau der Diode wird im Verlauf ihres Herstellungsverfahrens beispielsweise Indium-Gallium-Arsenidphosphid auf Indiumphosphid abgeschieden. Abgesehen von der Notwendigkeit des Mesa-Aufbaues ist bei diesen bekannten Dioden das Produkt aus Schichtdicke und Dotierung nur schwer mit der an sich erforderlichen Toleranz einzustellen.

Planare Fotodioden mit auf Indium-Gallium-Arsenid oder Indium-Gallium-Arsenidphosphid abgeschiedenem Indiumphosphid und mit langwelliger Empfindlichkeitsgrenze über 1,36 µm werden mit Hilfe der Gasphasen-Epitaxie hergestellt. Der pn-Übergang wird bei diesen Dioden mit Hilfe einer p-dotierenden Diffusion erzeugt, wobei als Diffusionsmaske eine Schicht aus dielektrischem Material — wie z. B. Siliziumnitrid oder Siliziumdioxid — benutzt wird. Einzelheiten zu diesem Stand der Technik lassen sich aus « IEEE J. Quant. Electr. », Bd. 17 (1981), Seite 250-254 entnehmen.

Mit Gasphasen-Epitaxie hergestellte Dioden mit Hilfe der Flüssigphasen-Epitaxie herzustellen — und dabei wenigstens vergleichbar hohe Qualität der Dioden zu erreichen — stößt auf das Problem, daß sich Indiumphosphid auf einer Indium-Gallium-Arsenidphosphid-Schicht mit so hohem Arsengehalt, daß eine genügend hohe Grenzwellenlänge von möglichst > 1,3 µm erreicht wird, sehr schwierig abscheiden läßt.

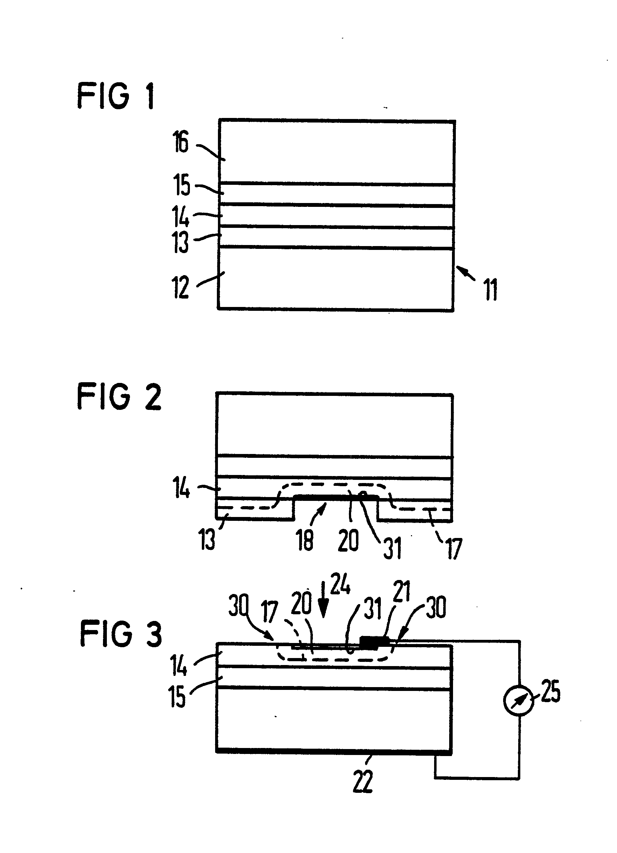

Zur Lösung des voranstehenden Problems ist in « IEEE J. Quant. Electr. » Bd. 17 (1981) S. 250 bis 254, insbesondere Fig. 1, angegeben, diese Indiumphosphidschicht auf der Indium-Gallium-Arsenid-Schicht mit Gasphasen-Epitaxie abzuscheiden, wohingegen die übrigen Schichten mit Flüssigphasen-Epitaxie abgeschieden sind. Dieser Wechsel des Epitaxieverfahrens ist technologisch umständlich.

Die Druckschrift « Jap. Journal of Appl. Phys. » Bd. 20 (1981) S. L313-L316 beschreibt ebenfalls die Probleme, wie sie mit der Flüssigphasen-Epitaxie-Abscheidung von Indiumphosphid auf Indium-Gallium-Arsenidphosphid, nämlich infolge des Auftretens einer Rückschmelze des quaternären Halbleitermaterials, bei einem solchen Material mit hohem Arsengehalt ergeben.

In « Journal Appl. Phys. », Bd. 51 (1981) S. 2255-2257 ist Flüssigphasen-Epitaxie auf einem Cadmium-Tellurid-Substratkörper für eine Schichtfolge von Quecksilber-Cadmium-Tellurid mit relativ hohem Quecksilbergehalt Cadmium-Tellurid für einen Fotodetektor beschrieben.

In « Electr. Lett. » Bd. 17 (1981) S. 826-827 ist eine planare Avalanche-Fotodiode für 1,3 µm Lichtwellenlänge beschrieben, wobei es dort auf das Vorhandensein einer zweistufigen Schutzringstruktur ankommt. Die erste Stufe der Schutzringstruktur ist mit Hilfe von Ionenimplantation hergestellt. Die zweite Stufe der Schutzringstruktur besteht in einer n-Indiumphosphid-Schicht, die mit Flüssigphasen-Epitaxie auf einer n-Indiumphosphidschicht abgeschieden ist. Weitere Einzelheiten hinsichtlich des Herstellungsverfahrens dieser aus mehreren Schichten bestehenden Fotodiode, unter denen sich auch eine quaternäre Indium-Gallium-Arsenidphosphid-Schicht befindet, sind dort nicht angegeben.

In applied Physics Letters, Band 35, Nr 3, August 1979, Seiten 251-253 ist eine durch Flüssigphasen-Epitaxie hergestellte InGaAsP Heterostruktur-Avalanche-Fotodiode beschrieben.

Es ist Aufgabe der vorliegenden Erfindung, für ein Verfahren nach dem Oberbegriff des Patentanspruchs 1 solche Verbesserungen anzugeben, daß die Herstellung von Fotodioden mit Avalanche-Effekt für einen Wellenlängenbereich über 1,3 µm bis möglichst 1,65 µm ohne Einbuße an Qualität und Leistungsfähigkeit der Dioden technologisch vereinfacht wird.

Diese Aufgabe wird erfindungsgemäß mit den Merkmalen des Kennzeichens des Anspruchs 1 gelöst. Ausgestaltungen und Weiterbildungen der Erfindung gehen aus den Unteransprüchen hervor.

Der vorliegenden Erfindung liegt der Wunsch zugrunde, mit Flüssigphasen-Epitaxie arbeiten zu können. Damit ergibt sich die Möglichkeit, Halbleiterschichten mit niedrigerer Restdotierung von z. B. unter $10^{16}$ cm$^{-3}$ und/oder großer Ladungsträger-Lebensdauer ohne größeren technologischen Aufwand herzustellen. Eine unter Anwendung des erfindungsgemäßen Verfahrens hergestellte Diode weist außer dem Trägerkörper, der für die mechanische Halterung der Diode zu verwenden ist, eine Halbleiterschicht aus z. B. Indiumphosphid mit übereinanderliegend p-dotiertem Schichtbereich und n-dotiertem Schichtbereich (so daß in dem Indiumphosphid ein pn-Übergang vorliegt) auf. Die Diode hat außerdem eine auf das Indiumphosphid aufgewachsene Schicht aus z. B. Indium-Gallium-Arsenidphosphid, die zur Absorption der zu detektierenden Lichtstrahlung vorgesehen ist. Durch entsprechend hohen Arsengehalt läßt sich die langwellige Absorptionskante des Materials zu größeren Wellenlängenwerten hin verschieben. Im n-Indiumphosphid befindet sich die Zone hohen elektrischen Feldes und damit der Avalanche-Multiplikation. In der Schicht aus Indium-Gallium-Arsenidphosphid muß dagegen zur Vermeidung eines großen Sperrstromes die im Betrieb auftretende Feldstärke klein sein. Die dort herrschende Feldstärke dient lediglich zum Sammeln der durch Strahlungsabsorption erzeugten Ladungsträger. Das Produkt aus Dotierung un Schichtdicke des n-Indiumphosphid-Schichtbereiches läßt sich — wie aus dem nachfolgenden noch näher hervorgeht — bei der Erfindung mit kleiner Toleranz von z. B. unter ± 20 % genau einstellen.

Anstelle von Indium-Gallium-Arsenidphosphid für die Absorptionsschicht kann auch das ternäre Material Indium-Gallium-Arsenid für Absorption von Strahlung bis zu 1,6 µm Wellenlänge vorgesehen sein. Weitere Beispiele für Materialkombinationen einer erfindungsgemäßen Diode sind Galliumantimonid für die Schichten mit pn-Übergang, Indium-Arsenantimonid für die Absorptionsschicht sowie Kadmiumtellurid für die Schichten mit pn-Übergang, Quecksilber-Kadmiumtellurid für die Absorptionsschicht. In allen Fällen einer erfindungsgemäßen Diode ist der Trägerkörper auf der einen Seite der Absorptionsschicht aufgewachsen, die mit ihrer anderen gegenüberliegenden Oberfläche auf die Schicht aufgewachsen ist, in der schließlich der pn-Übergang vorhanden ist. Diese Schicht mit dem pn-Übergang grenzt daher an die äußere Oberfläche des gesamten Diodenkörpers an und der pn-Übergang in dieser Schicht ist durch Eindiffusion und/oder Implantation von entsprechendem Dotierungsmaterial in das Halbleitermaterial dieser Schicht erzeugt, das vorzugsweise bereits mit einer entsprechenden (entgegengesetzten) Hintergrunddotierung epitaktisch aufgewachsen worden ist. Dieser Dotierungsschritt ist unter Verwendung einer Maske ausgeführt, die bei der Herstellung einer erfindungsgemäßen Diode gemäß einem Merkmal der Erfindung eine Halbleiterschicht war, auf der in einem früheren Herstellungsschritt die Halbleiterschicht aufgewachsen worden war, in der später der pn-Übergang erzeugt worden ist. Als Halbleitermaterial für diese Maskierungsschicht ist ein solches verwendet worden, auf dem nicht nur das Halbleitermaterial für den pn-Übergang sich epitaktisch gut aufwachsen läßt, sondern das sich in Bezug auf dieses Material gut selektiv ätzen läßt. Zum Beispiel läßt sich das bereits erwähnte Indiumphosphid auf das Indium-Gallium-Arsenidphosphid selbst bei hohem Arsengehalt gut aufwachsen und dieses Indium-Gallium-Arsenidphosphid läßt sich mit beispielsweise $H_2SO_4 + H_2O_2 + H_2O$ (3 : 1 : 1) vergleichsweise zum Indiumphosphid selektiv ätzen. Es läßt sich also in diese Maskierungsschicht ohne weiteres ein Loch bzw. eine Maskenöffnung ätzen, wobei das darunterliegende Indiumphosphid nur ganz wenig — jedoch auch später noch nachweisbar — angeätzt wird. Das insoweit im Rahmen der Erfindung angewendete Herstellungsverfahren läßt sich somit sogar noch an der fertigen Diode nachweisen, bei der schließlich nach erfolgter Dotierung für den pn-Übergang auch das restliche Material der epitaktisch aufgewachsenen Maske entfernt worden ist.

Weitere Erläuterungen der Erfindung werden anhand der beigefügten Figuren gegeben.

Es zeigen

Figur 1  das nach Durchführung der ersten vier Epitaxieabscheidungen erreichte Ergebnis.

Figur 2  das Ergebnis der Maskierung und Erzeugung des pn-Übergangs.

Figur 3  eine nach der Erfindung hergestellte Detektor-(Foto-) Diode.

Ausgangspunkt für eine erfindungsgemäße Diode kann ein vorgegebenes Halbleitermaterial, wie z. B. Indiumphosphid für diejenige Schicht sein, in der der pn-Übergang zu realisieren ist. Bekanntermaßen ist Indiumphosphid in Bezug auf hohen Avalanche-Effekt, d. h. mit großem Verstärkungsgrad günstig.

Mit 11 ist in Figur 1 insgesamt ein aus Substratkörper, Trägerkörper und drei Epitaxieschichten insgesamt epitaktisch aufgebauter Körper bezeichnet. Das als Ausgangsmaterial verwendete Substrat ist mit 12 bezeichnet. Mit 13 ist eine auf dem Substrat 12 abgeschiedene erste Schicht bezeichnet, die in einem späteren Verfahrensschritt als Maskierungsschicht zur Erzeugung des pn-Überganges in der darauffolgenden Schicht 14 aus, wie hier beispielsweise vorgegebenen Indiumphosphid dient. Als Auswahlkriterien für ein Material der Schicht 13 gelten, daß das (vorgegebene) Material der Schicht 14 sich auf dem Material der Schicht 13 epitaktisch abscheiden lassen muß, daß das Material der Schicht 13 sich auf dem Substrat 12 abscheiden lassen muß. Da die Schicht 13 als Maskierungsschicht verwendet werden soll, nämlich nachdem der Substratkörper 12 durch Ätzen entfernt worden ist, ergeben sich die weiteren Auswahlkriterien, daß das Material der Schicht 12 vergleichsweise zu denjenigen der Schicht 13 selektiv ätzbar sein muß und daß auch das Material der Schicht 13 gegenüber dem Material der Schicht 14 selektiv ätzbar sein muß und außerdem das Material der Schicht 13 einen Diffusionskoeffizienten für das später in die Schicht 14 einzubringende Dotierungsmittel haben muß, der wenigstens nicht wesentlich größer als der Diffusionskoeffizient für dieses Dotierungsmittel im Material der Schicht 14 ist. Für Indiumphosphid als Material der Schicht 14 eignet sich als Material für die Schicht 13 Indium-Gallium-Arsenidphosphid mit (vergleichsweise zum Material der noch zu beschreibenden Schicht 15) geringem Arsengehalt. Für den Substratkörper 12 kann wieder Indiumphosphid verwendet werden. Es bedarf an sich keiner besonderen Erwähnung, daß die Gitterkonstanten entsprechend den Vorbedingungen für Epitaxie weitestgehend übereinstimmen. Durch Wahl des Indium-Gallium-Verhältnis im Indium-Gallium-Arsenidphosphid kann eine durch Arsengehalt an sich auftretende Gitterkonstantenveränderung rückgängig gemacht werden.

Voranstehend ist erwähnt, daß das Material der Schicht 14, in der der pn-Übergang ist, als Ausgangspunkt dienen kann. Genauer betrachtet ist für die Wahl eines solchen Ausgangspunktes aber auch das Material der Schicht 15, die nachfolgend auf der Schicht 14 epitaktisch abgeschieden ist, zu berücksichtigen. Das Material dieser Schicht 15 dient nämlich bei der fertigen Diode dazu, als Absorptionsschicht für die zu detektierende Strahlung wirksam zu sein. Eine für eine Fotodiode mit Avalanche-Effekt günstige Kombination ist z. B. Indiumphosphid für die Schicht 14 mit Avalanche-Effekt und Indium-Gallium-Arsenidphosphid für die Absorptionsschicht 15, wobei höherer Arsengehalt die gesamte Diode für längerwelliges Ultrarot verwendbar macht.

Tatsächlich ist die epitaktische Abscheidung von Indium-Gallium-Arsenidphosphid mit auch hohem Arsengehalt auf Indiumphosphid mit Erfolg durchführbar. Es ist aber dagegen sehr problematisch, Indiumphosphid auf eben diesem Indium-Gallium-Arsenidphosphid abzuscheiden, da dabei ein Anlösen des Indium-Gallium-Arsenidphosphids eintritt, so daß das abzuscheidende Indiumphosphid und die dabei epitaktisch entstehende Schicht unerwünschte Verunreinigungen erfährt.

Da beim erfindungsgemäßen Verfahren der Substratkörper 12 entfernt werden muß, wird schließlich weiteres Halbleitermaterial, z. B. Indiumphosphid, auf der Schicht 15 epitaktisch abgeschieden. Es entsteht dabei der später als Trägerkörper benutzte Anteil 16 des Körpers 11. Das Indiumphosphid des Trägerkörpers 16 wird hier aus einer Zinnschmelze epitaktisch ausgeschieden, aus der Indiumphosphid auch auf Indium-Gallium-Arsenidphosphid bei selbst hohem Arsengehalt epitaktisch abscheidbar ist. Für die Epitaxie der Schichten 13 bis 15 muß dagegen eine Indiumschmelze (für die als Beispiel angegebenen abzuscheidenden Materialien) verwendet werden.

Mit der Erfindung läßt sich erreichen, daß nach selektivem Abätzen des ursprünglichen Substratkörpers 12 und nachfolgendem selektivem Einätzen der Maskierungsstruktur in die Schicht 13 ein Körper bestehend aus den Schichten 14 und 15 und dem Trägerkörper 16 entsteht, bei dem — abgesehen von der Maskierungsschicht 13 — die Schicht 14, in der der pn-Übergang herzustellen ist, oberste Schicht desjenigen Körpers ist, wie ihn Figur 2 zeigt.

Figur 2 zeigt diesen (nach Wegätzen des Substratkörpers 12 und Maskenherstellung aus der Schicht 13 entstandenen Körper, der nach bereits erfolgter Diffusion oder Implantation mit Dotierungsmittel einen pn-Übergang enthält, dessen Grenze durch die gestrichelte Linie 17 angedeutet ist. Mit 18 ist auf die Maskenöffnung in der Schicht 13 hingewiesen. Aufgrund etwa gleich großen, auf jeden Fall aber nicht wesentlich größeren Diffusionskoeffizienten in der Schicht 13 einerseits und in der Schicht 14 andererseits, erstreckt sich das dotierte Gebiet 20 bei entsprechender seitlicher Begrenzung bis zu einer bestimmten, exakt einstellbaren Grenze tief in die Schicht 14. Die Tiefe der Schicht 20 kann bis auf eine optimale Nähe an die Hetero-Übergangsgrenze zwischen den Schichten 14 und 15 herangerückt sein. Bei beispielsweise einer n-Hintergrunddotierung mit $10^{16}$ bis $10^{17}$ Teilchen pro $cm^3$ für das ursprüngliche Material der Schicht 14 ist für den Schichtbereich 20 eine p-Dotierung mit z. B. $10^{19}$ geeignet.

Figur 3 zeigt eine fertige erfindungsgemäße Diode (die in ihrer Darstellung vergleichsweise zu Figur 2 umgekehrt ist). Bei der Diode nach Figur 3 ist bereits die Maskierungsschicht 13 entfernt. Mit 21 und 22 sind elektrische Kontakte für den elektrischen Anschluß der fertigen Diode bezeichnet. Mit dem Pfeil 24 ist auf die zu detektierende, einfallende Strahlung, z. B. Ultrarotstrahlung, hingewiesen. Diese Strahlung 24 wird der Schicht 15 (entsprechend der Auswahl des Materials dieser Schicht) in relativ starkem Maße unter Ladungsträgererzeugung absorbiert. Durch das zwischen den Kontakten 21 und 22 anliegende elektrische Feld werden diese Ladungsträger in den Bereich des pn-Überganges 17 gezogen und führen durch Avalanche-Effekt verstärkt zu einem der Detektion entsprechenden Signalstrom 25.

Mit dem für die Erfindung vorgesehenen, oben beschriebenen Verfahren der Herstellung wird nicht nur erreicht, daß die Schicht 14 oberhalb der Schicht 15 liegt, obwohl die Schicht 14 seitlich vor der Schicht 15 epitaktisch abgeschieden worden ist. Ein weiterer besonderer Vorzug ist aber auch, daß eine Maske aus epitaktisch abgeschiedenem Material der Schicht 13 verwendet worden ist.

Es ist an sich üblich, Siliziumdioxid oder Siliziumnitrid oder dgl. als Maskierungsmaterial zu verwenden. Dies führt aber dazu, daß Oberflächenstörungen in der darunterliegenden Halbleiterschicht eintreten können, die dann zu Leckströmen in dem Bereich des pn-Überganges führen können, in dem der pn-Übergang auf die äußere Oberfläche des Körpers trifft. In der Figur 3 ist auf diese Stellen mit dem Bezugszeichen 30 und ihrem Pfeil hingewiesen.

Bei Verwendung einer epitaktisch aufgewachsenen Maske treten keine solche Leckströme verursachenden Störungen an derartigen Stellen auf. Das die Maskierungsschicht 13 durch selektives Abätzen später entfernt worden ist, läßt sich an der fertigen Diode durch einen von dem selektiven Abätzen der Schicht 13 herrührenden geringfügigen Ätzangriff der Schicht 14 erkennen, auf den mit der Linie 31 prinzipiell hingewiesen ist.

Die voranstehende Figurenbeschreibung enthält ein Beispiel einer Materialauswahl für eine erfindungsgemäße Diode bzw. für deren Herstellungsverfahren. Andere beispielhafte Materialkombinationen sind die folgenden :

1. Für die Schicht 14 mit hohem Avalanche-Effekt Gallium-Antimonid und für die Schicht 15 mit hoher Strahlungsabsorption Indium-Arsenid-Antimonid. Dazu ist eine als selektiv ätzbare und als Epitaxieunterlage für die Schicht 14 verwendbare Schicht 13 aus Indium-Gallium-Arsenid-Antimonid vorgesehen und als Substrat 12 Gallium-Antimonid zu verwenden. Für den Trägerkörper 16 kann dann wieder Gallium-Antimonid verwendet werden.

2. Für die Schicht 14 mit hohem Avalanche-Effekt Kadmium-Tellurid und für die Schicht 15 mit hoher Strahlungsabsorption Quecksilber-Kadmium-Tellurid mit höherem Quecksilbergehalt. Dazu ist eine als selektiv ätzbare und als Epitaxieunterlage für die Schicht 14 verwendbare Schicht 13 aus Quecksilber-Kadmium-Tellurid mit wenig Quecksilber vorgesehen und als Substrat 12 Kadmium-Tellurid zu verwenden. Für den Trägerkörper 16 kann dann wieder Kadmium-Tellurid verwendet werden.

**Patentansprüche**

1. Verfahren zur Herstellung einer planaren Avalanche-Fotodiode mit langwelliger Empfindlichkeitsgrenze über 1,3 μm, bei dem mehrere übereinanderliegende Schichten aus Halbleitermaterial epitaktisch auf einem Substratkörper abgeschieden werden, von denen eine Schicht aus einem Material mit möglichst hoher Absorption der für die Fotodiode vorgegebenen Strahlung besteht und mit Flüssigphasenepitaxie abgeschieden wird, wobei diese Schicht mit der daran angrenzenden Schicht, auf die die nachzuweisende Strahlung auffällt, einen Heteroübergang bildet, bei dem in dieser angrenzenden, eine Untergrunddotierung aufweisenden Schicht durch Einbringen von Dotierungsmaterial ein pn-Übergang mit Avalanche-Effekt erzeugt wird und bei dem anschließend Elektrodenanschlüsse angebracht werden, gekennzeichnet dadurch, daß auf dem lediglich für die Schichtabscheidung vorgesehenen Substratkörper (12) eine erste Schicht (13) und dann eine zweite Schicht (14) mit Flüssigphasenepitaxie abgeschieden werden, wobei diese zweite Schicht (14) für die Ausbildung des pn-Übergangs (17) vorgesehen ist, wobei das Material der ersten Schicht (13) bezogen auf das Material der zweiten Schicht (14) selektiv ätzbar sein muß, wobei das Material des Substratkörpers (12) bezogen auf das Material der ersten Schicht (13) selektiv ätzbar sein muß und wobei der Diffusionskoeffizient des für die zweite Schicht (14) vorgesehenen Dotierungsmittels für das Material der ersten Schicht (13) wenigstens nicht wesentlich größer als für das Material der zweiten Schicht (14) ist, daß auf der zweiten Schicht (14) eine dritte Schicht (15) mit Flüssigphasenepitaxie abgeschieden wird, die aus dem Material besteht, das für die für die Fotodiode vorgegebene Strahlung die möglichst hohe Absorption hat und das mit dem Material der zweiten Schicht (14) den Heteroübergang bildet, daß auf die dritte Schicht (15) weiteres Halbleitermaterial für einen Trägerkörper (16) epitaktisch abgeschieden wird, daß anschließend der Substratkörper (12) selektiv weggeätzt wird, daß auf fotolithografischem Wege in die erste Schicht (13) für die nachfolgende Erzeugung des pn-Überganges (17) in der zweiten Schicht (14) eine entsprechende Maskenöffnung (18) selektiv hereingeätzt wird, wobei die zweite Schicht (14) nur oberflächlich angeätzt wird, daß durch Implantation und/oder Diffusion durch diese Maskenöffnung hindurch das Dotierungsmaterial in die zweite Schicht (14) eingebracht wird und daß anschließend vor dem Anbringen der Elektrodenanschlüsse (21, 22) der Rest der ersten Schicht (13) durch selektives Ätzen entfernt wird.

2. Verfahren nach Anspruch 1, bei dem für den Substratkörper Indiumphosphid, für die Schicht möglichst hoher Absorption Indium-Gallium-Arsenidphosphid mit relativ hohem Arsenidgehalt und für die den pn-Übergang aufweisende Schicht Indiumphosphid verwendet wird, dadurch gekennzeichnet, daß für die erste Schicht (13) Indium-Gallium-Arsenidphosphid mit relativ geringem Arsenidgehalt und für den Trägerkörper (16) Indiumphosphid verwendet wird und daß die epitaktische Abscheidung für die erste, zweite und dritte Schicht (13, 14, 15) aus einer Indiumschmelze erfolgt und die epitaktische Abscheidung des Trägerkörpers (16) aus einer Zinnschmelze erfolgt.

3. Verfahren nach Anspruch 1, dadurch gekennzeichnet, daß für den Substratkörper (12) Gallium-Antimonid, für die erste Schicht (13) Indium-Gallium-Arsenid-Antimonid, für die zweite Schicht (14) Gallium-Antimonid, für die dritte Schicht (15) Indium-Arsenid-Antimonid und für den Trägerkörper (16) Gallium-Antimonid verwendet wird.

4. Verfahren nach Anspruch 1, dadurch gekennzeichnet, daß für den Substratkörper (12) Cadmium-Tellurid, für die erste Schicht (13) Quecksilber-Cadmium-Tellurid mit wenig Quecksilber, für die zweite Schicht (14) Cadmium-Tellurid, für die dritte Schicht (15) Quecksilber-Cadmium-Tellurid mit höherem Quecksilbergehalt und für den Trägerkörper (16) Cadmium-Tellurid verwendet wird.

**Claims**

1. A process for the production of a planar avalanche-photo-diode with a long-wave sensitivity limit of above 1.3 μm, in which a plurality of layers of semiconductor material, arranged one above another, are epitaxially deposited on to a substrate body, of which one layer consists of a material with the highest possible absorption of the radiation provided for the photo-diode and is deposited by liquid phase epitaxy, where this layer forms a hetero-junction with the adjoining layer on to which the radiation which is to be detected falls, where a pn-junction with an avalanche effect is produced in this adjoining layer which is provided with a background doping, by the introduction of doping material, and where finally electrode terminals are applied, characterised in that on to the substrate body (12), which is provided only for the layer deposition, a first layer (13) is deposited and then a second layer (14), using liquid phase epitaxy, where the second layer (14) serves for the formation of the pn-junction (17), where the material of the first layer (13) must be able to be selectively etched in relation to the material of the second layer (14), where the material of the substrate body (12) must be able to be selectively etched in relation to the material of the first layer (13), and where the diffusion coefficient of the dopant for the second layer (14), is not substantially greater for this material of the first layer (13) than for the material of the second layer (14), that a third layer (15) is deposited on to the second layer (14) by means of liquid phase epitaxy, where said third layer (15) consists of the material which has the highest possible absorption for the radiation provided for the photo-diode and which forms the hetero-junction with the material of the second layer (14), that further semiconductor material for a carrier body (16) is epitaxially deposited on to the third layer (15), that then the substrate body (12) is selectively etched away, that using photolithography a suitable mask opening (18) is selectively etched into the first layer (13) for the subsequent formation of the pn-junction (17) in the second layer (14), the second layer (14) being etched only at its surface, that by means of implantation and/or diffusion, the doping material is introduced through this mask opening into the second layer (14), and that then, prior to the application of the electrode terminals (21, 22), the remainder of the first layer (13) is removed by selective etching.

2. A process as claimed in Claim 1, wherein indium phosphide is used for the substrate body, indium-gallium arsenide-phosphide with a relatively high arsenide content is used for the layer which has the highest possible absorption, and indium phosphide is used for the layer which contains the pn-junction, characterised in that indium-gallium arsenide-phosphide with a relatively low arsenide content is used for the first layer (13), and indium phosphide is used for the carrier body (16), and that the first, second and third layers (13, 14, 15) are epitaxially deposited from an indium melt and the carrier body (16) is epitaxially deposited from a tin melt.

3. A process as claimed in Claim 1, characterised in that gallium-antimonide is used for the substrate body (12), indium-gallium arsenide-antimonide is used for the first layer (13), gallium antimonide is used for the second layer (14), indium arsenide-antimonide is used for the third layer (15), and gallium antimonide is used for the carrier body (16).

4. A process as claimed in Claim 1, characterised in that cadmium telluride is used for the substrate body (12), mercury-cadmium telluride with a low mercury content is used for the first layer (13), cadmium telluride is used for the second layer (14), mercury-cadmium telluride with a higher mercury content is used for the third layer (15), and cadmium telluride is used for the carrier body (16).

**Revendications**

1. Procédé pour la fabrication d'une photo-diode à avalanche, de type planar, ayant une limite de sensibilité de grande longueur d'onde supérieure à 1,3 μm, selon lequel on dépose, par épitaxie, plusieurs couches superposées de maté-riaux semi-conducteurs sur un substrat, dont une couche est constituée d'un matériau ayant une absorption aussi élevée que possible du rayonnement préfixé pour la photodiode et qui est déposée par épitaxie en phase liquide, cette couche formant une hétérojonction avec la couche voisine sur laquelle tombe le rayonnement à détecter, selon lequel on crée une jonction pn à effet d'avalanche dans cette couche voisine, présentant un dopage de fond, par introduction de matériau dopant et selon lequel on forme ensuite des connexions d'électrodes, caractérisé en ce que l'on dépose, sur le substrat (12), qui est seulement prévu pour le dépôt de couches, une première couche (13) puis une deuxième couche (14), par épitaxie en phase liquide, la deuxième couche (14) étant prévue pour la formation de la jonction pn (17), le matériau de la première couche (13) devant pouvoir être gravé sélectivement par rapport au matériau de la deuxième couche (14), le matériau du substrat (12) devant pouvoir être gravé sélectivement par rapport au matériau de la première couche (13), et le coefficient de diffusion du dopant prévu pour la deuxième couche (14) ne devant pas être nettement plus grand, au moins, pour le matériau de la première couche (13) que pour le matériau de la deuxième couche (14), que l'on dispose sur la deuxième couche (14), par épitaxie en phase liquide, une troisième couche (15) faite du matériau ayant l'absorption la plus haute possible pour le rayonnement préfixé pour la photodiode et qui forme l'hétérojonction avec le matériau de la deuxième couche (14), que l'on dépose sur la troisième couche (15), par épitaxie, du matériau semi-conducteur supplémentaire pour un support (16), que l'on élimine ensuite le substrat (12) par une gravure sélective, que l'on grave sélectivement une fenêtre de masque (18) par voie photolithographique dans la première couche (13) pour la création consécutive de la jonction pn dans la deuxième couche (14), laquelle est seulement attaquée superficiellement par la gravure, que l'on introduit le dopant par implantation et/ou diffusion à travers cette fenêtre dans la deuxième couche (14) et que, ensuite, avant la formation des connexions d'électrodes (21, 22), on enlève le reste de la première couche (13) par gravure sélective.

2. Procédé selon la revendication 1, selon lequel on utilise du phosphure d'indium pour le substrat, de l'arséniophosphure d'indium-gallium à relativement haute teneur en arseniure pour la couche ayant une absorption aussi haute que possible, ainsi que du phosphure d'indium pour la couche présentant la jonction pn, caractérisé en ce que l'on utilise de l'arséniophosphure d'indium-gallium à relativement faible teneur en arseniure pour la première couche (13) et du phosphure d'indium pour le support (16), et que le dépôt par épitaxie pour les première, deuxième et troisième couches (13, 14, 15) s'opère à partir d'un bain d'indium et le dépôt par épitaxie du support (16) s'opère à partir d'un bain d'étain.

3. Procédé selon la revendication 1, caractérisé en ce que l'on utilise de l'antimoniure de gallium pour le substrat (12), de l'arsénio-antimoniure d'indium-gallium pour la première couche (13), de l'antimoniure de gallium pour la deuxième couche (14), de l'arsénio-antimoniure d'indium pour la troisième couche (15) et de l'antimoniure de gallium pour le support (16).

4. Procédé selon la revendication 1, caractérisé en ce que l'on utilise du tellurure de cadmium pour le substrat (12), du tellurure de mercure-cadmium avec peu de mercure pour la première couche (13), du tellurure de cadmium pour la deuxième couche (14), du tellurure de mercure-cadmium à plus forte teneur en mercure pour la troisième couche (15) et du tellurure de cadmium pour le support (16).

FIG 1

FIG 2

FIG 3

1